# EUROPEAN PATENT APPLICATION

(11) **EP 3 842 228 A1**
(43) Date of publication of application: **30.06.2021**
(21) Application number: 19853125.3
(22) Date of filing: 20.08.2019
(51) Int. Cl.: B32B 15/08, H05K 3/38

(54) **LAMINATE, MOLDED ARTICLE, CONDUCTIVE PATTERN AND ELECTRONIC CIRCUIT**

(30) Priority: 23.08.2018 JP 2018156375
(71) Applicant: DIC Corporation, Tokyo 174-8520 (JP)
(72) Inventor: FUJIKAWA, Wataru, Takaishi-shi, Osaka 592-0001 (JP); FUKAZAWA, Norimasa, Takaishi-shi, Osaka 592-0001 (JP); SHIRAKAMI, Jun, Takaishi-shi, Osaka 592-0001 (JP)
(74) Representative: TBK
(86) International application number: PCT/JP2019/032392
(87) International publication number: WO 2020/040120

(57) **Abstract**

The present invention provides a multilayer body including a substrate (A) including a polyphenylene sulfide resin composition and a primer layer (X), a metal layer (B), and a metal plating layer (C) that are stacked on and above the substrate (A), the primer layer (X) including an aromatic resin (x1) having an epoxy group and a molded article, a conductive pattern, and an electronic circuit that include the multilayer body. The multilayer body includes a polyphenylene sulfide substrate and a metal plating layer stacked above the substrate and has an excellent adhesion strength to the metal plating layer and suitable heat resistance with which an excellent adhesion strength can be maintained even when the multilayer body is subjected to a high-temperature environment.

## Description

### Technical Field

The present invention relates to a multilayer body that can be used as a molded article, such as a connector used for the connection of wires for electronic circuits, optical communication, or the like or a light reflector, or as a conductive pattern included in wired electronic circuits, such as a printed circuit board, an electromagnetic shielding material, an integrated circuit, and an organic transistor, and to a molded article, a conductive pattern, and an electronic circuit that include the multilayer body.

### Background Art

With improvement in the performance of electronic devices and reductions in the sizes and thicknesses of electronic devices, there has been a strong demand for increases in the densities of the electronic circuits and integrated circuits included in such electronic devices. Attention has been focused on polyphenylene sulfide, which is an engineering plastic having suitable heat resistance and chemical resistance and used for producing optical pickups for Blu-ray Discs, DVDs, and the like, electronic circuit boards, wire connectors, film capacitors, and the like. In the automotive application, polyphenylene sulfide is used for producing a light reflector, an electrical component, an electric motor-related component, a battery component, and the like.

However, the adhesion strength between polyphenylene sulfide and metal films formed by metal vapor deposition, metal plating, or the like is considerably poor. Therefore, it is not suitable to use polyphenylene sulfide in the case where a metal film is required on the surface of polyphenylene sulfide.

There has been proposed a method for increasing the adhesion strength between polyphenylene sulfide and a metal film, in which the surface of polyphenylene sulfide is etched with an etching agent, a palladium catalyst is subsequently applied to the etched surface, and electroless copper plating is then performed to form a copper plating layer (e.g., see PTL 1). However, in the above method, the etching agent corrodes and weakens the surface of polyphenylene sulfide and consequently increases the likelihood of the copper plating layer formed on the surface of polyphenylene sulfide being peeled off with time. Thus, in the case where a conductive pattern is formed by the above method, wire disconnection and a reduction in electrical conductivity (increase in resistance) may occur in the copper plating layer.

There has also been proposed a method in which the surface of polyphenylene sulfide is roughened by sand blasting, shot blasting, or the like and a primer resin is coated onto the surface of polyphenylene sulfide in order to increase an adhesion strength to coating layers formed by metal vapor deposition, metal plating, or the like (e.g., see PTL 2). However, the surface of polyphenylene sulfide is roughened to a depth of 1 to 10 µm in order to achieve a sufficient adhesion strength. Therefore, the above method is not suitable for producing materials that is required to have surface smoothness comparable to specular surface, such as a light reflector.

Accordingly, there has been a demand for a multilayer body that includes a polyphenylene sulfide substrate, has an excellent adhesion strength to a metal film formed on the substrate by metal vapor deposition, metal plating, or the like, and can be used as a molded article, such as a connector used for the connection of wires for electronic circuits, optical communication, or the like or a light reflector, or as a conductive pattern included in wired electronic circuits, such as a printed circuit board, an electromagnetic shielding material, an integrated circuit, and an organic transistor.

### Citation List

### Patent Literature

PTL 1: Japanese Unexamined Patent Application Publication No. S63-14880
PTL 2: Japanese Unexamined Patent Application Publication No. 2002-97292

### Summary of Invention

### Technical Problem

An object of the present invention is to provide a multilayer body including a polyphenylene sulfide substrate and a metal plating layer stacked above the substrate and has an excellent adhesion strength to the metal plating layer and suitable heat resistance with which an excellent adhesion strength can be maintained even when the multilayer body is subjected to a high-temperature environment. Another object of the present invention is to provide a molded article, a conductive pattern, and an electronic circuit that include the multilayer body.

### Solution to Problem

The inventors of the present invention conducted extensive studies in order to achieve the above objects and consequently found that forming a primer layer including an aromatic resin having an epoxy group on a substrate including polyphenylene sulfide may increase an adhesion strength to a metal plating layer to an excellent degree and enhance heat resistance to a degree at which an excellent adhesion strength can be maintained even when the multilayer body is subjected to a high-temperature environment. Thus, the present invention was made.

Accordingly, the present invention provides a multilayer body including a substrate (A) including a polyphenylene sulfide resin composition and a primer layer (X), a metal layer (B), and a metal plating layer (C) that are stacked on and above the substrate (A), the primer layer (X) including an aromatic resin having an epoxy group and a molded article, a conductive pattern, and an electronic circuit that include the multilayer body.

### Advantageous Effects of Invention

The multilayer body according to the present invention offers an excellent adhesion strength between the substrate including a polyphenylene sulfide resin composition and the metal plating layer stacked on the substrate and can maintain an excellent adhesion strength even when the multilayer body is subjected to a high-temperature environment. Thus, the present invention provides a multilayer body that maintains excellent electrical conductivity without causing wire disconnection or the like and can be used for producing highly reliable conductive patterns and electronic circuits.

The multilayer body according to the present invention may be used for producing connectors used for the connection of wires for electronic circuits, optical communication, and the like, optical pickups for Blu-ray Discs, DVDs, and the like; light reflectors, electrical components, electric motor-related components, and battery components for automobiles; electromagnetic shielding materials included in various electronic devices; and the like. The multilayer body according to the present invention may also be used as building components such as a faucet component. The multilayer body according to the present invention including a film-form polyphenylene sulfide substrate may also be used for forming flexible printed circuit boards, RFID included in contactless integrated circuit cards and the like, layers constituting film capacitors, peripheral wires, and the like.

### Description of Embodiments

The multilayer body according to the present invention includes a substrate (A) including a polyphenylene sulfide resin composition, a primer layer (X) stacked on the substrate (A), a metal layer (B) stacked on the primer layer (X), and a metal plating layer (C) stacked on the metal layer (B), the primer layer (X) including an aromatic resin having an epoxy group.

The polyphenylene sulfide has a resin structure including a repeating unit that is a structure constituted by an aromatic ring and a sulfur atom bonded to the aromatic ring. Specifically, the polyphenylene sulfide is a resin including a repeating unit that is the structural site represented by General Formula (1) below. 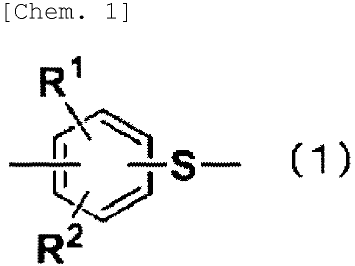 (In General Formula (1), R¹ and R² each independently represent a hydrogen atom, an alkyl group having 1 to 4 carbon atoms, a nitro group, an amino group, a phenyl group, a methoxy group, or an ethoxy group)

In General Formula (1), R¹ and R² are preferably hydrogen atoms in order to increase the mechanical strength of the polyphenylene sulfide (a1). In such a case, examples of the structure of the repeating unit include the structure represented by General Formula (2) below in which the sulfur atom is bonded to the aromatic ring at a para-position and the structure represented by General Formula (3) below in which the sulfur atom is bonded to the aromatic ring at a meta-position.

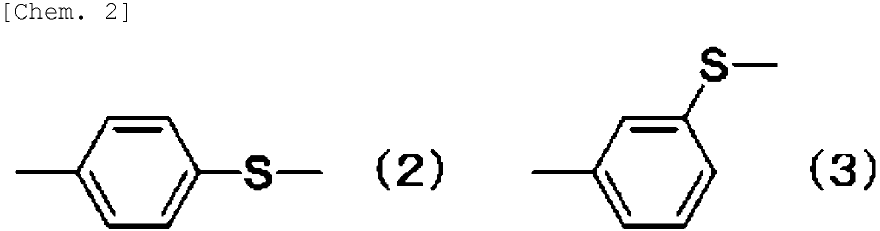

Among these, in particular, the structure of the repeating unit in which the sulfur atom is bonded to the aromatic ring at a para-position as illustrated in General Formula (2) above is preferable in order to enhance the heat resistance and crystallinity of the polyphenylene sulfide.

The polyphenylene sulfide may optionally include at least one selected from the structural sites represented by General Formulae (4) to (7) below in addition to the structural site represented by General Formula (1) above. In the case where the polyphenylene sulfide includes any of the structural sites represented by General Formulae (4) to (7) below, the molar ratio of the above structural sites to the polyphenylene sulfide is preferably 30 mol% or less and is more preferably 10 mol% or less in order to enhance heat resistance and increase mechanical strength.

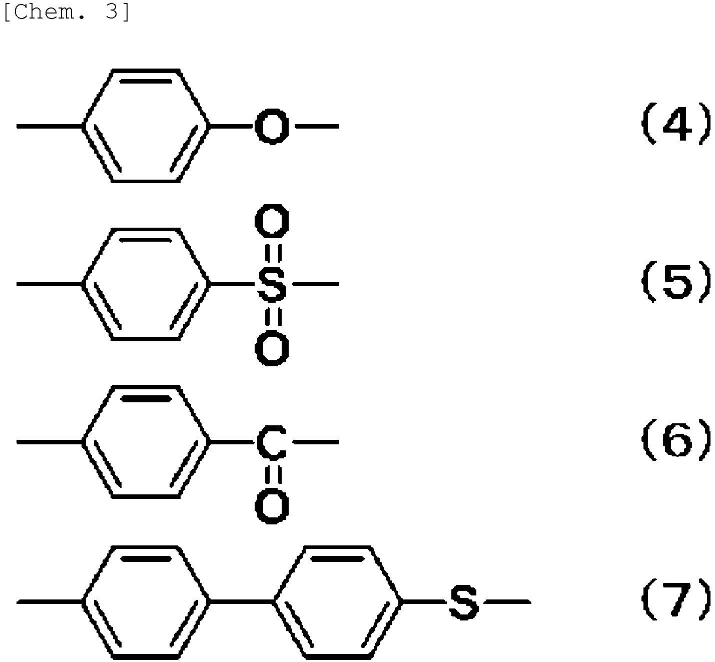

In the case where the polyphenylene sulfide includes any of the structural sites represented by General Formulae (4) to (7) above, the mode in which the structural sites are bonded to the repeating unit that is the structural site represented by General Formula (1) above may be a random mode or a block mode.

The structure of the polyphenylene sulfide may further include the trifunctional structural site represented by General Formula (8) below, such as a naphthyl sulfide bond. In such a case, the molar ratio of the above structural sites to the polyphenylene sulfide is preferably 3 mol% or less and is particularly more preferably 1 mol% or less.

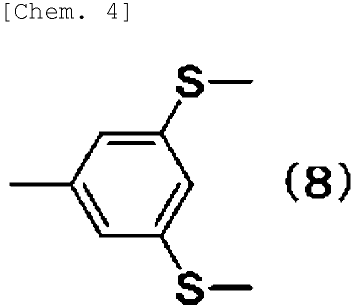

The polyphenylene sulfide may be produced by, for example, any of the methods (1) to (4) described below.
(1) A method in which the reaction between sodium sulfide and p-dichlorobenzene is conducted in an amide solvent, such as N-methylpyrrolidone or dimethylacetamide, or in a sulfone solvent, such as sulfolane.
(2) A method in which p-dichlorobenzene is polymerized in the presence of sulfur and sodium carbonate.
(3) A method in which sodium sulfide, a mixture of sodium hydrosulfide and sodium hydroxide, or a mixture of hydrogen sulfide and sodium hydroxide is added dropwise to a mixed solvent of a polar solvent and p-dichlorobenzene to cause polymerization.
(4) A method in which self-condensation of p-chlorothiophenol is performed.

Among these, the method (1), that is, the method in which the reaction between sodium sulfide and p-dichlorobenzene is conducted in an amide solvent, such as N-methylpyrrolidone or dimethylacetamide, or in a sulfone solvent, such as sulfolane, is preferable in order to readily control the reaction and increase industrial productivity. In the method (1), it is preferable to use an alkali, such as an alkali metal salt of carboxylic acid, an alkali metal salt of sulfonic acid, or a hydroxide, in order to control the degree of polymerization.

The melt flow rate (hereinafter, abbreviated as "MFR") of the polyphenylene sulfide is preferably 1 to 3,000 g/10 min, is more preferably 5 to 2,300 g/10 min, and is further preferably 10 to 1,500 g/10 min in order to enhance formability and increase surface strength. Note that the melt flow rate is measured at 316°C/5,000 g load (orifice: 0.0825 ± 0.002 inch diameter × 0.315 ± 0.001 inch length) in accordance with ASTM D1238-86.

Subsequent to the production of the polyphenylene sulfide, the polyphenylene sulfide is preferably subjected to an acid treatment and then cleaned with water in order to reduce the amount of residual metal ions, thereby enhance moisture resistance, and reduce the amount of low-molecular-weight impurities produced in the polymerization reaction as a by-product.

It is preferable to use acetic acid, hydrochloric acid, sulfuric acid, phosphoric acid, silicic acid, carbonic acid, propionic acid, or the like as an acid for the acid treatment. Among the above acids, acetic acid and hydrochloric acid are preferable in order to efficiently reduce the amount of residual metal ions without decomposing the polyphenylene sulfide.

Examples of the method for performing the acid treatment include a method in which the polyphenylene sulfide is immersed in acid or an aqueous solution of an acid. Furthermore, stirring or heating may be performed as needed.

An acid treatment method in which acetic acid is used is described below as a specific example of the method for performing the acid treatment. An aqueous solution of acetic acid with a pH of 4 is heated to 80°C to 90°C. The polyphenylene sulfide is immersed in the aqueous solution. Subsequently, stirring is performed for 20 to 40 minutes.

The polyphenylene sulfide that has been subjected to the acid treatment as described above is cleaned with water or warm water several times in order to physically remove the remaining acids and salts. The water used for the cleaning is preferably distilled water or deionized water.

It is preferable that the polyphenylene sulfide be subjected to the acid treatment in the form of powder particles. Specifically, the polyphenylene sulfide may be subjected to the acid treatment in the form of granules, such as pellets, or in the form of a slurry subsequent to the polymerization reaction.

It is preferable to mix an elastomer with the substrate (A) including the polyphenylene sulfide resin composition. While the elastomer is used to impart flexibility and low-temperature impact resistance to the polyphenylene sulfide resin composition constituting the substrate (A), the elastomer also increases an adhesion strength to the primer layer (X).

It is preferable that the elastomer can be melt-kneaded with the polyphenylene sulfide to form a uniform dispersion. Specifically, the elastomer preferably has a melting point of 300°C or less and exhibits rubber elasticity at room temperature.

Examples of the elastomer include thermoplastic elastomers, such as a polyolefin elastomer and an olefin copolymer elastomer. Specific examples thereof include a styrene-butadiene rubber (SBR), a hydrogenated SBR, an ethylene-propylene rubber (EPM), an ethylene-propylene-diene rubber (EPDM), a butadiene rubber, a chloroprene rubber, a nitrile rubber, a butyl rubber, an acrylic rubber, a silicone rubber, a fluorine-containing rubber, and a urethane rubber. Among these, an olefin copolymer elastomer is preferable, an ethylene copolymer elastomer is more preferable, and an ethylene copolymer elastomer having a glycidyl group is further preferable in order to further increase an adhesion strength to the primer layer (X). The above elastomers may be used alone or in combination of two or more.

Examples of the ethylene copolymer elastomer include a binary copolymer produced using monomer components that are ethylene and maleic anhydride, or ethylene and an **α,β-**unsaturated carboxylic acid glycidyl ester, as raw materials. Examples of the ethylene copolymer elastomer further include a ternary copolymer produced further using an **α,β**-unsaturated carboxylic acid alkyl ester in addition to the two monomer components of the above binary copolymer. Among these, the ternary copolymer is preferable in order to enhance bending elasticity and tensile elongation. Among such ternary copolymers, a ternary copolymer produced using ethylene, an **α,β**-unsaturated carboxylic acid alkyl ester, and an **α,β**-unsaturated carboxylic acid glycidyl ester is more preferable in order to markedly enhance compatibility with the polyphenylene sulfide and further increase an adhesion strength to the primer layer (X).

In order to enhance the impact resistance and tensile elongation of the polyphenylene sulfide resin composition, compatibility with the polyphenylene sulfide (a1), and the like in a balanced manner, in the case where a ternary copolymer constituted by [ethylene/**α,β**-unsaturated carboxylic acid alkyl ester/maleic anhydride] is used, the proportions of the monomer components in the ternary copolymer is preferably [50 to 98/1 to 30/1 to 30] by mass. In the case where a ternary copolymer constituted by [ethylene/**α,β**-unsaturated carboxylic acid alkyl ester/**α,β-**unsaturated carboxylic acid glycidyl ester] is used, the proportions of the monomer components in the ternary copolymer is preferably [50 to 98/1 to 49/1 to 10] by mass.

Examples of the **α,β**-unsaturated carboxylic acid alkyl ester include alkyl esters of unsaturated carboxylic acids having 3 to 8 carbon atoms, such as acrylic acid and methacrylic acid. Specific examples thereof include methyl acrylate, ethyl acrylate, n-propyl acrylate, isopropyl acrylate, n-butyl acrylate, t-butyl acrylate, isobutyl acrylate, methyl methacrylate, ethyl methacrylate, n-propyl methacrylate, isopropyl methacrylate, n-butyl methacrylate, t-butyl methacrylate, and isobutyl methacrylate. Among these, methyl acrylate, ethyl acrylate, n-butyl acrylate, and methyl methacrylate are preferable in order to further enhance the impact resistance of the polyphenylene sulfide resin composition and further increase an adhesion strength to the primer layer (X).

The content of the elastomer in the polyphenylene sulfide resin composition is 0.3 to 90 parts by mass relative to 100 parts by mass of the polyphenylene sulfide. In order to further enhance the workability of the polyphenylene sulfide resin composition and further increase an adhesion strength to the primer layer (X), the content of the elastomer is preferably 0.5 to 60 parts by mass, is more preferably 1 to 40 parts by mass, and is further preferably 2 to 20 parts by mass.

Adding a fibrous inorganic filler to the polyphenylene sulfide resin composition constituting the substrate (A) in addition to the above polyphenylene sulfide and the above elastomer may further enhance heat resistance, mechanical properties, dimensional stability, crystallization speed, and electrical characteristics.

Examples of the fibrous inorganic filler include inorganic fibers, such as a glass fiber, a carbon fiber, zinc oxide whiskers, an asbestos fiber, a silica fiber, aluminum borate whiskers, a silica-alumina fiber, a zirconia fiber, a boron nitride fiber, a silicon nitride fiber, and a potassium titanate fiber; and metal fibers made of stainless steel, aluminum, titanium, copper, brass, or the like. Among these, a glass fiber is preferable because it has high electrical insulating properties. The above fibrous inorganic fillers may be used alone or in combination of two or more.

The fibrous inorganic filler is preferably treated with a surface-treating agent or a sizing agent in order to increase an adhesion strength to the polyphenylene sulfide, the ester wax, and the other additives described below.

Examples of the surface-treating agent or sizing agent include silane and titanate compounds having a functional group such as an amino group, an epoxy group, an isocyanate group, or a vinyl group; and polymers such as an acrylic resin, a urethane resin, and an epoxy resin.

The content of the fibrous inorganic filler in the polyphenylene sulfide resin composition is preferably 10 to 150 parts by mass, is more preferably 30 to 100 parts by mass, and is further preferably 50 to 80 parts by mass relative to 100 parts by mass of the polyphenylene sulfide in order to produce the above-described advantageous effects to a sufficient degree.

The polyphenylene sulfide resin composition constituting the substrate (A) may optionally include, in addition to the above polyphenylene sulfide, the above elastomer, and the above fibrous inorganic filler component, the following various additives and the like such that the advantageous effects of the present invention are not impaired: inorganic fillers other than the fibrous inorganic filler, such as calcium carbonate, magnesium carbonate, or talc; high-heat-resistance resin fibers, such as an aramid fiber; resins such as polyamide, polysulfone, polyarylsulfone, polyethersulfone, polyarylate, polyphenylene oxide, polyether ketone, polyether ether ketone, polyimide, polyamide imide, polyether imide, a silicone resin, a phenoxy resin, a fluororesin, a liquid crystal polymer, and a polyaryl ether; and a lubricant, a wax, and a stabilizer.

The method for preparing the polyphenylene sulfide resin composition is not limited; the polyphenylene sulfide resin composition may be prepared using any of the known manufacturing apparatuses and methods. For example, the polyphenylene sulfide resin composition may be produced by mixing the components, such as the polyphenylene sulfide, the elastomer, and the fibrous inorganic filler, with one another using a mixing machine such as a Henschel mixer or a tumbler, feeding the resulting mixture to a single- or twinscrew extruder or the like, kneading the mixture at 250°C to 350°C, and performing granulation to form pellets.

The polyphenylene sulfide resin composition may be formed into the substrate (A) by, for example, molding the pellets of the polyphenylene sulfide resin composition prepared by the above preparation method by injection molding, extrusion molding, compression molding, or the like.

The shape of the substrate (A) is not limited. The substrate (A) preferably has a thickness of about 0.5 to 100 mm and more preferably has a thickness of about 0.5 to 10 mm. The substrate (A) may have a three-dimensional shape formed using a mold, such as a connector component.

The substrate (A) may be film-form or sheet-form. The thickness of the film-form or sheet-form substrate (A) is preferably about 1 to 5,000 **µ**m and is more preferably about 1 to 300 **µ**m. In the case the multilayer body according to the present invention is required to be relatively flexible, the substrate (A) preferably has a thickness of about 1 to 200 **µ**m.

In order to increase the adhesion strength between the substrate (A) and the primer layer (X), the surface of the substrate (A) may be subjected to a surface treatment for forming fine irregularities in the surface of the substrate (A), removing stains adhered on the surface of the substrate (A), and introducing a functional group such as a hydroxyl group, a carbonyl group, or a carboxyl group. Specifically, for example, a dry processing, such as a plasma discharge treatment, a corona discharge treatment, or an ultraviolet treatment, or a wet processing using water, an aqueous solution of an acid, an alkali, or the like, an organic solvent, or the like may be performed.

The primer layer (X) is a layer including an aromatic resin having an epoxy group. The aromatic resin is a resin including an aromatic ring in the chemical structure of the resin. Since an aromatic resin including an aromatic ring has high heat resistance, it is possible to directly make use of high heat resistance of the polyphenylene sulfide resin composition constituting the substrate (A).

The aromatic resin having an epoxy group may be any resin that include an epoxy group and an aromatic ring. Examples of such a resin include an epoxy resin and an acrylic resin. Either low-molecular-weight or high-molecular-weight resins may be used.

Examples of the epoxy resin include a bisphenol A-type epoxy resin, a bisphenol F-type epoxy resin, a biphenyl-type epoxy resin, a cresol novolac-type epoxy resin, a phenol novolac-type epoxy resin, a bisphenol A novolac-type epoxy resin, a tetrabromobisphenol A-type epoxy resin, a naphthalene-type epoxy resin, a phosphorus-containing epoxy compound having a structure derived from a 9,10-dihydro-9-oxa-10-phosphaphenanthrene-10-oxide derivative, a phenol novolac-type epoxy resin having a structure derived from a dicyclopentadiene derivative, and a cresol novolac-type epoxy resin having a structure derived from a dicyclopentadiene derivative. The above epoxy resins may be used alone or in combination of two or more.

Among the above epoxy resins, a bisphenol A-type epoxy resin, a bisphenol F-type epoxy resin, and a naphthalene-type epoxy resin are preferably used in order to further increase the adhesion strength between the substrate and the metal layer including the metal plating layer. It is more preferable to use an epoxy resin (multifunctional epoxy resin) having a low molecular weight and a high concentration of functional group per molecule. The term "adhesion strength" used hereinafter refers to the adhesion strength between the substrate and the metal layer including the metal plating layer, unless otherwise specified.

Examples of the acrylic resin include acrylic resins produced by copolymerizing the essential raw material that is a (meth)acrylic monomer including an epoxy group with another (meth)acrylic monomer. The term "(meth)acrylic monomer" used herein refers to either or both of an acrylic monomer and a methacrylic monomer. The term "(meth)acrylic acid" used herein refers to either or both of an acrylic acid and a methacrylic acid. The term "(meth)acrylate" used herein refers to either or both of an acrylate and a methacrylate.

Examples of the (meth)acrylic monomer including an epoxy group include glycidyl (meth)acrylate, 4-hydroxybutyl acrylate glycidyl ether, and allyl glycidyl ether. Among the above (meth)acrylic monomers including an epoxy group, glycidyl methacrylate is preferable in order to further increase the adhesion strength. The above (meth)acrylic monomers including an epoxy group may be used alone or in combination of two or more.

A polymerizable monomer other than the (meth)acrylic monomer including an epoxy group which is copolymerizable with the (meth)acrylic monomer including an epoxy group may be used as a raw material for the acrylic resin. Examples of the other polymerizable monomer include (meth)acrylic acid esters, such as methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, tert-butyl (meth)acrylate, pentyl (meth)acrylate, hexyl (meth)acrylate, cyclohexyl (meth)acrylate, n-octyl (meth)acrylate, 2-ethylhexyl (meth)acrylate, nonyl (meth)acrylate, dodecyl (meth)acrylate, stearyl (meth)acrylate, isobornyl (meth)acrylate, tricyclodecanyl (meth)acrylate, adamantyl (meth)acrylate, dicyclopentanyl (meth)acrylate, phenyl (meth)acrylate, benzyl (meth)acrylate, 2,2,2-trifluoroethyl (meth)acrylate, 2,2,3,3-pentafluoropropyl (meth)acrylate, perfluorocyclohexyl (meth)acrylate, 2,2,3,3-tetrafluoropropyl (meth)acrylate, **β**-(perfluorohexyl)ethyl (meth)acrylate, ethylene glycol di(meth)acrylate, polyethylene glycol di(meth)acrylate, propylene glycol di(meth)acrylate, polypropylene glycol di(meth)acrylate, butylene glycol di(meth)acrylate, polybutylene glycol di(meth)acrylate, neopentyl glycol di(meth)acrylate, polyneopentyl glycol di(meth)acrylate, and tricyclodecanedimethanol di(meth)acrylate; acrylamide compounds, such as N,N'-methylenebis(meth)acrylamide and N,N'-ethylenebis(meth)acrylamide; and styrenes, such as styrene and **α**-methylstyrene, and derivatives thereof. Among the above other polymerizable monomers, styrene is preferable in order to further increase the adhesion strength. The other polymerizable monomers may be used alone or in combination of two or more.

The acrylic resin may be produced by polymerizing a mixture including the above (meth)acrylic monomers, etc. by a known polymerization method. Examples of the polymerization method include methods in which polymerization is performed in an organic solvent, such as solution polymerization; methods in which polymerization is performed in an aqueous medium, such as emulsion polymerization, suspension polymerization, and precipitation polymerization; and methods in which polymerization is performed without any solvent, such as bulk polymerization.

Examples of the polymerization initiator used in the production of the acrylic resin include azo initiators, such as azonitrile, azo-ester, an azoamide, an azoamidine, and an azoimidazoline; organic peroxides, such as peroxy ketal, hydroperoxide, dialkyl peroxide, diacyl peroxide, peroxy dicarbonate, and peroxy ester; and inorganic peroxides, such as ammonium persulfate, potassium persulfate, and hydrogen peroxide.

Radical polymerization may be performed using any of the above peroxides only. Alternatively, polymerization may be performed using a redox polymerization initiator system in which any of the above peroxides is used in combination with a reductant such as ascorbic acid, erythorbic acid, sodium erythorbate, a metal salt of formaldehyde sulfoxylate, sodium thiosulfate, sodium bisulfite, or ferric chloride.

The epoxy group concentration in the acrylic resin is preferably 0.05 to 8 mmol/g, is more preferably 0.5 to 3 mmol/g, and is further preferably 1 to 2.5 mmol/g in order to further increase the adhesion strength.

As described above, the primer layer (X) is a layer including the aromatic resin having an epoxy group. Adding a carboxylic acid to the primer layer (X) in addition to the aromatic resin may further increase the adhesion strength.

The carboxylic acid may be either a low-molecular-weight or high-molecular-weight carboxylic acid. The carboxylic acid may be a carboxylic anhydride. Specific examples of the carboxylic acid include aromatic carboxylic acids, such as phthalic acid, isophthalic acid, terephthalic acid, trimellitic acid, pyromellitic acid, mellitic acid, biphenyldicarboxylic acid, biphenyltetracarboxylic acid, and naphthalenedicarboxylic acid, and anhydrides of the above aromatic carboxylic acids; and aliphatic carboxylic acids, such as oxalic acid, malonic acid, succinic acid, methylsuccinic anhydride, ethylsuccinic anhydride, glutaric acid, adipic acid, pimelic acid, suberic acid, azelaic acid, sebacic acid, dodecanedioic acid, maleic acid, fumaric acid, 2,3-butanedicarboxylic acid, 2,4-pentanedicarboxylic acid, 3,5-heptanedicarboxylic acid, hexahydrophthalic acid, methylhexahydrophthalic acid, tetrahydrophthalic acid, norbornene-2,3-dicarboxylic acid, methylnorbornene-2,3-dicarboxylic acid, 1,2,4-cyclohexanetricarboxylic acid, dodecylsuccinic acid, nadic acid, methylnadic acid, and bicyclo[2.2.2]octane-2,3-dicarboxylic acid, and anhydrides of the above aliphatic carboxylic acids.

Examples of the high-molecular-weight carboxylic acid include polyacrylic acid, an acrylic resin produced by copolymerization of monomers including a carboxyl group, a polyester resin including carboxyl groups at the terminals, and a urethane resin including carboxyl groups at the terminals.

Among the above carboxylic acids, polyvalent carboxylic acids are preferable in order to further increase the adhesion strength. Among the polyvalent carboxylic acids, low-molecular-weight polyvalent carboxylic acids are preferable and aromatic polyvalent carboxylic acids are preferable in order to further increase the adhesion strength. Specifically, trimellitic anhydride and pyromellitic anhydride are preferable. The above carboxylic acids may be used alone or in combination of two or more.

In the case where the primer layer (X) includes the carboxylic acid (x2), the molar ratio [(xA)/(xE)] of the carboxyl group (xA) included in the carboxylic acid to the epoxy group (xE) included in the aromatic resin is preferably 0.01 to 1, is more preferably 0.01 to 0.5, and is further preferably 0.01 to 0.25, in order to further increase the adhesion strength.

A curing catalyst may optionally be used to facilitate the reaction between the epoxy group and the carboxyl group. Examples of the curing catalyst include a tertiary amine, an imidazole compound, an organic phosphine, and a Lewis acid catalyst.

Examples of the tertiary amine include trimethylamine, triethylamine, tripropylamine, tributylamine, triamylamine, trihexylamine, trioctylamine, trilaurylamine, dimethylethylamine, dimethylpropylamine, dimethylbutylamine, dimethylamylamine, dimethylhexylamine, dimethylcyclohexylamine, dimethyloctylamine, dimethyllaurylamine, triallylamine, tetramethylethylenediamine, triethylenediamine (triethylenetetramine: TETA), N-methylmorpholine, 4,4'-(oxydi-2,1-ethanediyl)bis-morpholine, N,N-dimethylbenzylamine, pyridine, picoline, dimethylaminomethylphenol, trisdimethylaminomethylphenol, triethanolamine, N,N'-dimethylpiperazine, tetramethylbutanediamine, bis(2,2-morpholinoethyl)ether, bis(dimethylaminoethyl)ether, N,N',N"- tris(dimethylaminopropyl)hexahydro-s-triazine, N,N',N'' - tris(dimethylaminoethyl)hexahydro-s-triazine, N,N',N'' - tris(2-hydroxyethyl)hexahydro-s-triazine, 2,4-diamino-6-[2'-methylimidazolyl-(1')]-ethyl-s-triazine, 1,8-diazabicyclo[5.4.0]undecene-1,1,4-diazabicyclo[2.2.2]octane, and 1,8-diazabicyclo[5.4.0]undec-7-ene (DBU).

Examples of the imidazole compound include 1-benzyl-2-imidazole (1B2MZ), 2-ethyl-4-imidazole, 2-undecylimidazole, 1,2-dimethylimidazole, 1-benzyl-2-phenylimidazole, 2-methylimidazole, 2-ethyl-4-methylimidazole, and 2-phenyl-4-methyl-5-hydroxymethylimidazole (2P4MHZ).

Examples of the organic phosphine include triphenylphosphine (TPP), triphenylphosphine-triphenyl borate, tris(p-methoxyphenyl)phosphine, and tetraphenylphosphonium-tetraphenyl borate.

Examples of the Lewis acid catalyst include a boron trifluoride-amine complex, a boron trichloride-amine complex, and a boron trifluoride-ethylamine complex.

Among the above curing catalysts, the tertiary amine and the imidazole compound are preferably used in order to further increase the adhesion strength. The above curing catalysts may be used alone or in combination of two or more.

For forming the primer layer (X) on the substrate (A), it is preferable to prepare a primer composition (x) including the aromatic resin (x1) and, as needed, the carboxylic acid (x2) and coat the primer composition (x) to the substrate (A). The primer composition (x) may further include a resin other than the aromatic resin (x1) or the carboxylic acid (x2). Examples of the other resin include a urethane resin, an acrylic resin, a blocked isocyanate resin, a melamine resin, and a phenolic resin. The above other resins may be used alone or in combination of two or more.

When the primer composition (x) is coated on the substrate (A), it is preferable to dilute the primer composition (x) with a solvent in order to reduce viscosity to a degree at which the primer composition (x) is easily coated to the substrate (A). Examples of the solvent that can be used for the primer include various organic solvents and aqueous media. Examples of the organic solvents include toluene, ethyl acetate, methyl ethyl ketone, and cyclohexanone. Examples of the aqueous media include water, an organic solvent miscible with water, and a mixture of water and such an organic solvent.

Examples of the organic solvent miscible with water include alcohol solvents, such as methanol, ethanol, n-propanol, isopropanol, ethyl carbitol, ethyl cellosolve, and butyl cellosolve; ketone solvents, such as acetone and methyl ethyl ketone; alkylene glycol solvents, such as ethylene glycol, diethylene glycol, and propylene glycol; polyalkylene glycol solvents, such as polyethylene glycol, polypropylene glycol, and polytetramethylene glycol; and lactam solvents, such as N-methyl-2-pyrrolidone.

The amount of the solvent used is preferably adjusted appropriately in accordance with the coating method used for coating the primer composition (x) to the substrate (A) and the intended thickness of the primer layer (X). Specifically, it is preferable to use the solvent such that the resin proportion in the primer composition (x) is 1% to 70% by mass. It is more preferable to use the solvent such that the above resin proportion is 1% to 20% by mass.

To the primer composition (x), optionally, known additives, such as a coating layer-formation assistant, a leveling agent, a thickener, a water repellent, an antifoaming agent, and an antioxidant, may be added as needed.

The primer layer (X) may be formed by, for example, coating the primer composition (x) onto a part or the entirety of the surface of the substrate (A) and subsequently removing the solvent, such as the organic solvent, included in the primer composition (x).

Examples of the method for coating the primer composition (x) onto the surface of the substrate (A) include a gravure method, a coating method, a screen method, a roller method, a rotary method, a spray method, a capillary method, a dipping method, and a spray method.

After the primer composition (x) has been coated onto the surface of the substrate (A), for removing the organic solvent included in the resulting coating layer, for example, it is common to dry the coating layer with a dryer to volatilize the organic solvent. The drying temperature may be set to fall within the temperature range in which the organic solvent used can be volatilized and no adverse effect, such as heat deformation, occurs to the substrate (A) .

The amount of the primer coated on the substrate (A) per unit area of the substrate is preferably 0.01 to 60 g/m² in order to increase the adhesion strength to an excellent degree and is more preferably 0.01 to 10 g/m² in consideration of a capability to absorb the solvent included in the fluid described below and the manufacturing costs.

The thickness of the primer layer (X) differs depending on the use of the multilayer body according to the present invention. The thickness of the primer layer (X) is preferably 10 nm to 30 **µ**m, is more preferably 10 nm to 1 **µ**m, and is further preferably 10 to 500 nm in order to further increase the adhesion strength between the substrate (A) and the metal layer (B).

The surface of the primer layer (X) may optionally be subjected to a surface treatment by dry processing, such as a plasma discharge treatment method, a corona discharge treatment method, or an ultraviolet treatment method, or by wet processing using water, an aqueous solution of an acid or alkali, an organic solvent, or the like as needed, in order to further increase an adhesion strength to the metal layer (B).

After the primer has been coated onto the surface of the substrate, for removing the solvent included in the resulting coating layer, for example, it is common to dry the coating layer with a dryer to volatilize the solvent. The drying temperature may be set to fall within the temperature range in which the solvent used can be volatilized and no adverse effect occurs to the substrate (A) .

The metal layer (B) is stacked on the primer layer (X). Examples of the metal constituting the metal layer (B) include transition metals and compounds of transition metals. Among these, ionic transition metals are preferable. Examples of the ionic transition metals include copper, silver, gold, nickel, palladium, platinum, cobalt, and chromium. Among the above ionic transition metals, copper, silver, and gold are preferable in order to form conductive patterns having low electrical resistance and high corrosion resistance. The metal layer (B) is preferably porous. In such a case, the metal layer (B) has voids formed therein.

Examples of the metal constituting the metal plating layer (C) include copper, silver, gold, nickel, chromium, cobalt, and tin. Among these, copper is preferable in order to form conductive patterns having low electrical resistance and high corrosion resistance.

In the multilayer body according to the present invention, it is preferable that the voids present inside the metal layer (B) be filled with the metal constituting the metal plating layer (C). It is preferable that even a part of the voids of the metal layer (B) which are located in the vicinity of the interface between the substrate (A) and the metal layer (B) be filled with the metal constituting the metal plating layer (C), in order to further increase the adhesion strength between the metal layer (B) and the metal plating layer (C).

Examples of the method for producing the multilayer body according to the present invention include a method in which a fluid containing a nano-sized metal powder and a dispersant is coated to the substrate (A), the resulting coating layer is baked to remove the organic compounds, such as the dispersant, present in the coating layer formed of the fluid and thereby create voids in order to form a porous metal layer (B), and a metal plating layer (C) is subsequently formed thereon by electrolytic or electroless plating.

The nano-sized metal powder used in the formation of the metal layer (B) may have any shape that allows the formation of the porous metal layer and preferably has a particulate or fibrous shape. While the metal powder is nano-sized, specifically, in the case where the metal powder has a particulate shape, the average particle size of the metal powder is preferably 1 to 100 nm and is more preferably 1 to 50 nm in order to form fine conductive patterns and further reduce resistance measured after baking. The term "average particle size" used above refers to volume-average particle size determined by diluting the conductive substance with a dispersion good solvent and then conducting a measurement by dynamic light scattering. In this measurement, "Nanotrac UPA-150" produced by Microtrac may be used.

In the case where the particles of the metal powder are fibrous, the diameter of the fibers is preferably 5 to 100 nm and is more preferably 5 to 50 nm in order to form fine conductive patterns and further reduce resistance measured after baking. The length of the fibers is preferably 0.1 to 100 **µ**m and is more preferably 0.1 to 30 **µ**m.

In the formation of the metal layer (B) on the primer layer (X), it is preferable to coat a fluid prepared by dispersing the nano-sized metal powder in a solvent to the primer layer (X).

The content of the nano-sized metal powder in the fluid is preferably 1% to 90% by mass and is more preferably 5% to 60% by mass.

Examples of the components of the fluid include a dispersant used for dispersing the nano-sized metal powder in a solvent, the solvent, and, as needed, the organic compounds described below, such as a surfactant, a leveling agent, a viscosity modifier, a film-formation assistant, an antifoaming agent, and an antiseptic agent.

A dispersant having a low or high molecular weight is used for dispersing the nano-sized metal powder in a solvent. Examples of the dispersant include dodecanethiol, 1-octanethiol, triphenylphosphine, dodecylamine, polyethylene glycol, polyethyleneimine, and polyvinylpyrrolidone; fatty acids, such as myristic acid, octanoic acid, and stearic acid; and polycyclic hydrocarbon compounds including a carboxyl group, such as cholic acid, glycyrrhizic acid, and abietic acid. Among these, high-molecular-weight dispersants are preferable in order to increase the sizes of the voids formed in the metal layer (B) and thereby increase the adhesion strength between the metal layer (B) and the metal plating layer (C) described below. Preferable examples of the high-molecular-weight dispersants include polyalkyleneimines, such as polyethyleneimine and polypropyleneimine, and compounds produced by adding a polyoxyalkylene to the polyalkyleneimines.

Using a high-molecular-weight dispersant as a dispersant as described above increases the size of the voids formed in the metal layer (B) when the dispersant is removed compared with the case where a low-molecular-weight dispersant is used and enables the formation of voids having sizes of the orders of nanometers to submicrons. This makes it easy to fill the voids with the metal constituting the metal plating layer (C) described below. The metal charged in the voids serves as an anchor, which markedly increases the adhesion strength between the metal layer (B) and the metal plating layer (C).

The amount of the dispersant required for dispersing the nano-sized metal powder is preferably 0.01 to 50 parts by mass and is more preferably 0.01 to 10 parts by mass relative to 100 parts by mass of the nano-sized metal powder.

In order to increase the ease of forming the voids in the metal layer (B) by removing the dispersant and further increase the adhesion strength between the metal layer (B) and the metal plating layer (C), the amount of the dispersant used is preferably 0.1 to 10 parts by mass and is more preferably 0.1 to 5 parts by mass relative to 100 parts by mass of the nano-sized metal powder.

The solvent included in the fluid may be an aqueous medium or an organic solvent. Examples of the aqueous medium include distilled water, ion-exchange water, pure water, and ultrapure water. Examples of the organic solvent include an alcohol compound, an ether compound, an ester compound, and a ketone compound.

Examples of the alcohol include methanol, ethanol, n-propanol, isopropyl alcohol, n-butanol, isobutyl alcohol, sec-butanol, tert-butanol, heptanol, hexanol, octanol, nonanol, decanol, undecanol, dodecanol, tridecanol, tetradecanol, pentadecanol, stearyl alcohol, allyl alcohol, cyclohexanol, terpineol, dihydroterpineol, ethylene glycol monomethyl ether, ethylene glycol monoethyl ether, ethylene glycol monobutyl ether, diethylene glycol monoethyl ether, diethylene glycol monomethyl ether, diethylene glycol monobutyl ether, tetraethylene glycol monobutyl ether, propylene glycol monomethyl ether, dipropylene glycol monomethyl ether, tripropylene glycol monomethyl ether, propylene glycol monopropyl ether, dipropylene glycol monopropyl ether, propylene glycol monobutyl ether, dipropylene glycol monobutyl ether, and tripropylene glycol monobutyl ether.

The fluid may optionally include, in addition to the above metal powder and the above solvent, ethylene glycol, diethylene glycol, 1,3-butanediol, isoprene glycol, or the like as needed.

The surfactant may be a common surfactant. Examples of the surfactant include a di-2-ethylhexylsulfosuccinic acid salt, a dodecylbenzenesulfonic acid salt, an alkyldiphenyl ether disulfonic acid salt, an alkylnaphthalenesulfonic acid salt, and a hexametaphosphoric acid salt.

The leveling agent may be a common leveling agent. Examples thereof include a silicone compound, an acetylene diol compound, and a fluorine-containing compound.

The viscosity modifier may be a common thickener. Examples thereof include an acrylic polymer and a synthesis rubber latex that increase viscosity when the fluid is adjusted to be alkaline; and a urethane resin, hydroxyethyl cellulose, carboxymethyl cellulose, methyl cellulose, polyvinyl alcohol, a hydrogenated castor oil, an amide wax, oxidized polyethylene, metal soap, and dibenzylidene sorbitol that increase viscosity by the association of molecules.

The antifoaming agent may be a common antifoaming agent. Examples thereof include a silicone antifoaming agent, a nonionic surfactant, polyether, a higher alcohol, and a polymer surfactant.

The antiseptic agent may be a common antiseptic agent. Examples thereof include an isothiazoline antiseptic agent, a triazine antiseptic agent, an imidazole antiseptic agent, a pyridine antiseptic agent, an azole antiseptic agent, and a pyrithione antiseptic agent.

The viscosity (measured at 25°C with a Type-B viscometer) of the fluid is preferably 0.1 to 500,000 mPa·s and is more preferably 0.5 to 10,000 mPa·s. In the case where the fluid is coated (printed) on the primer layer (X) by the ink-jet printing method, the relief reverse printing method, or the like described below, the viscosity of the fluid is preferably 5 to 20 mPa·s.

Examples of the method for coating the fluid to the primer layer (X) include gravure printing, offset printing, flexographic printing, pad printing, gravure offset printing, letterpress printing, relief reverse printing, screen printing, microcontact printing, reverse printing, air doctor coating, blade coating, air knife coating, squeeze coating, impregnation coating, transfer roller coating, kiss coating, cast coating, spray coating, an ink jet method, die coating, spin coating, bar coating, and dip coating.

Among the above coating methods, ink-jet printing and reverse printing are preferably used in the case where a metal layer (B) patterned with thin lines having a thickness of about 0.01 to 100 **µ**m, which is required for increasing the densities of electronic circuits and the like, is formed.

The ink-jet printing method may be performed using an "ink jet printer". Specific examples thereof include Konica Minolta EB100 and XY100 (produced by Konica Minolta, Inc.), Dimatix Materials Printer DMP-3000, and Dimatix Materials Printer DMP-2831 (produced by Fujifilm Holdings Corporation) .

Known examples of the reverse printing method include relief reverse printing and intaglio reverse printing. For example, the fluid is coated onto the surface of a suitable blanket, which is then brought into contact with a plate having protrusions corresponding to non-printing portions in order to selectively transfer part of the fluid which corresponds to the non-printing portions onto the surface of the plate. Hereby, the pattern is formed on the surface of the blanket or the like. The pattern is subsequently transferred onto (the surface of) the substrate (A).

The metal layer (B) is produced by, for example, conducting a baking step subsequent to the coating of the fluid including the metal powder. The baking step causes particles of the metal powder included in the fluid to adhere and join to one another and thereby enables the formation of the metal layer (B) having electrical conductivity. It is preferable to conduct the baking step at 80°C to 300°C for about 2 to 200 minutes. The baking step may be conducted in the air. In order to avoid the entirety of the metal powder from being oxidized, part or the entirety of the baking step may be conducted in a reducing atmosphere.

The baking step causes particles of the particulate or fibrous metal powder used in the formation of the metal layer (B) to adhere and join to one another and removes the organic compounds, such as the dispersant, included in the fluid. This makes the metal layer (B) porous.

The baking step is conducted using, for example, an oven, a hot-air drying furnace, an infrared drying furnace, laser irradiation, microwave, or light irradiation (flash irradiation apparatus).

The amount of the metal layer (B) formed by the above baking step is preferably 1 to 30,000 mg/m², is more preferably 50 to 10,000 mg/m², and is further preferably 50 to 5,000 mg/m² in consideration of an adhesion strength to the metal plating layer (C) described below.

The organic compounds included in the fluid, such as the dispersant, which failed to be completely removed by the above baking step may be removed by, for example, a plasma discharge treatment method, an electromagnetic wave irradiation treatment method, a laser irradiation treatment method, or a dissolution treatment method in which the organic compounds, such as the dispersant, are re-dispersed and dissolved in water or an organic solvent. The above treatment methods may be used alone or in combination of two or more. It is preferable to use the above treatment methods in combination of two or more in order to remove the organic compounds with further efficiency. The term "organic compounds" used above refers to the components of the fluid, that is, organic compounds such as the dispersant, the solvent, the surfactant, the leveling agent, the viscosity modifier, the antifoaming agent, and the antiseptic agent.

Examples of the plasma discharge treatment method include atmospheric pressure plasma discharge treatment methods, such as a corona discharge treatment method; and vacuum plasma discharge treatment methods performed under vacuum or reduced pressure, such as a glow discharge treatment method and an arc discharge treatment method.

Examples of the atmospheric pressure plasma discharge treatment method include a method in which a plasma discharge treatment is performed in an atmosphere having an oxygen concentration of about 0.1% to 25% by volume. The oxygen concentration is preferably 10% to 22% by volume and is more preferably about 21% by volume (in an air atmosphere) in order to increase the adhesion strength between the metal layer (B) and the metal plating layer (C), make it easy to fill the voids of the porous metal layer (B) with the metal constituting the metal plating layer (C), and thereby increase the adhesion strength between the metal layer (B) and the metal plating layer (C).

The atmospheric pressure plasma discharge treatment method is preferably performed in an environment containing an inert gas in addition to the oxygen in order to further increase the adhesion strength between the metal layer (B) and the metal plating layer (C) without forming excessive irregularities in the surface of the metal layer (B). Examples of the inert gas include argon and nitrogen.

Examples of an apparatus that can be used for performing a treatment by the atmospheric pressure plasma discharge treatment method include the atmospheric pressure plasma treatment apparatus "AP-T01" produced by SEKISUI CHEMICAL CO., LTD.

In the treatment performed by the atmospheric pressure plasma discharge treatment method, the flow rate of the gas, such as air, is preferably 5 to 50 liter/min. The output is preferably 50 to 500 W. The treatment time is preferably 1 to 500 seconds.

Among the atmospheric pressure plasma discharge treatment methods, a corona discharge treatment method is preferably used. Examples of an apparatus that can be used in a corona discharge treatment method include corona surface modification test equipment "TEC-4AX" produced by KASUGA DENKI, Inc.

In the treatment performed by a corona discharge treatment method, the output is preferably 5 to 300 W. The treatment time is preferably 0.5 to 600 seconds.

The above plasma discharge treatment methods are preferable because they enable the removal of the organic compounds present in the metal layer (B) even at deep levels, that is, the removal of the organic compounds included in a portion of the metal layer (B) which is in the vicinity of the interface between the substrate (A) and the metal layer (B). Using the plasma discharge treatment method makes it easy to fill the voids of the porous metal layer (B) with the metal constituting the metal plating layer (C) in the formation of the metal plating layer (C) and increases ease of filling the voids of the metal layer (B) which are in the vicinity of the interface between the substrate (A) and the metal layer (B) with the metal constituting the metal plating layer (C). This allows the metal constituting the metal plating layer (C) to penetrate into the deeper levels of the metal layer (B) and produce a greater anchoring effect. Consequently, the adhesion strength between the metal layer (B) and the metal plating layer (C) may be markedly increased.

In the electromagnetic wave irradiation treatment method, the metal layer (B) is irradiated with an electromagnetic wave in order to heat the metal layer (B) to high temperatures and decompose and remove the organic compounds. The electromagnetic wave irradiation treatment can selectively remove the dispersant by using electromagnetic wave absorption resonance. Specifically, the wavelength of an electromagnetic wave that resonates with the organic compounds present in the metal layer (B) is determined, and the metal layer (B) is irradiated with an electromagnetic wave having the predetermined wavelength. This increases the absorption of the electromagnetic wave into the organic compounds (resonance) and enables only the dispersant to be removed by adjusting the intensity of the electromagnetic wave.

In the laser irradiation treatment method, the metal layer (B) is irradiated with a laser beam in order to decompose and remove the organic compounds included in the metal layer (B). In the laser irradiation treatment method, a laser capable of performing a laser scribing treatment may be used. Examples of the laser capable of performing a laser scribing treatment include a YAG laser, a CO₂ laser, and an excimer laser. In particular, a YAG laser is preferable. The 0.53 **µ**m second harmonic wave light obtained using a nonlinear optical element in combination with the 1.06 **µ**m fundamental wavelength light may be used as needed. The YAG laser is preferably a pulsed laser in order to achieve a high peak output and a high frequency.

A specific example of the method for irradiating the metal layer (B) with a laser beam is as follows. While the multilayer body is transported, a laser beam emitted from a laser beam source is collected and focused through a lens and the surface of the metal layer (B) is irradiated with the focused laser beam. In this process, the laser beam is moved using a polygon mirror such that the surface of the metal layer (B) of the transported multilayer body is scanned with the laser beam. This enables the metal layer (B) to be heated at high temperatures. In the laser irradiation treatment, the output of the laser beam is preferably 0.1 to 100 kW, the frequency (oscillation frequency) of pulse generation is preferably several kilohertz to several tens of kilohertz, and the duration of one pulse (pulse width) is preferably 90 to 100 nanoseconds.

The dissolution treatment method is a method in which the organic compounds present in the metal layer (B) are re-dispersed and dissolved in water or an organic solvent in order to remove the organic compounds. Examples of the organic solvent include alcohol solvents, such as methanol, ethanol, and isopropyl alcohol; polar aprotic solvents, such as dimethyl sulfoxide, dimethylformamide, and N-methylpyrrolidone; and tetrahydrofuran, methyl ethyl ketone, ethyl acetate, and Equamide (organic solvent produced by The Idemitsu Kosan Company, Ltd.).

For re-dispersing and dissolving the organic compounds, an acid or alkali is preferably used, and an alkali is more preferably used. Examples of the acid include sulfuric acid, nitric acid, hydrochloric acid, phosphoric acid, oxalic acid, acetic acid, formic acid, propionic acid, succinic acid, glutaric acid, tartaric acid, and adipic acid. Among these, strong acids such as sulfuric acid, nitric acid, and hydrochloric acid are preferably used. In the case where the metal plating layer (C) is formed by an electrolytic copper plating process using copper sulfate, sulfuric acid is preferably used in order to prevent the mixing of impurities in the subsequent step.

Examples of the alkali include sodium hydroxide, potassium hydroxide, lithium hydroxide, and calcium hydroxide; organic amines, such as ammonia, triethylamine, pyridine, and morpholine; and alkanolamines, such as monoethanolamine. Among these, strong alkalis, such as sodium hydroxide and potassium hydroxide, are preferably used.

For re-dispersing and dissolving the organic compounds, a surfactant may be used. The surfactant may be a common surfactant. Examples thereof include a di-2-ethylhexyl sulfosuccinic acid salt, an alkyl sulfate salt, an alkyl benzenesulfonic acid salt, and an alkyl diphenyl ether disulfonic acid salt. The above surfactants are more preferable because they become alkaline when dissolved in water and readily remove the organic compounds.

After the porous metal layer (B) having voids formed therein has been formed on the substrate (A) by removing the organic compounds as described above, the metal plating layer (C) is formed on the metal layer (B). Hereby, the multilayer body according to the present invention is produced.

The metal plating layer (C) is a layer provided for, for example, in the case where the multilayer body is used as a conductive pattern or the like, forming a highly reliable wire pattern capable of maintaining suitable electrical conductivity over a prolonged period of time without the occurrence of wire disconnection or the like.

The metal plating layer (C), which is a layer stacked on the metal layer (B), is preferably formed by a plating process. Examples of the plating process include wet plating methods, such as electrolytic plating and electroless plating; and dry plating methods, such as sputtering and vacuum vapor deposition. The above plating methods may be used in combination of two or more to form the metal plating layer (C).

Among the above plating processes, wet plating methods, such as electrolytic plating and electroless plating, are preferable, and electrolytic plating is more preferable in order to readily fill the voids of the porous metal layer (B) with the metal constituting the metal plating layer (C), thereby further increase the adhesion strength between the metal layer (B) and the metal plating layer (C), and consequently produce a conductive pattern having excellent electrical conductivity.

The electroless plating method is a method in which, for example, the metal constituting the metal layer (B) is brought into contact with an electroless plating solution in order to deposit the metal contained in the electroless plating solution, such as copper, and form an electroless plating layer (coating layer) that is a metal coating layer.

Examples of the electroless plating solution include a plating solution containing a metal, such as copper, nickel, chromium, cobalt, or tin; a reductant; and a solvent, such as an aqueous medium or an organic solvent.

Examples of the reductant include dimethylaminoborane, hypophosphorous acid, sodium hypophosphite, dimethylamineborane, hydrazine, formaldehyde, sodium borohydride, and phenol.

The electroless plating solution may optionally contain, as needed, the following complexing agents: organic acids, such as monocarboxylic acids, such as acetic acid and formic acid; dicarboxylic acid compounds, such as malonic acid, succinic acid, adipic acid, maleic acid, and fumaric acid; hydroxycarboxylic acid compounds, such as malic acid, lactic acid, glycol acid, gluconic acid, and citric acid; amino acid compounds, such as glycine, alanine, iminodiacetic acid, arginine, aspartic acid, and glutamic acid; aminopolycarboxylic acid compounds, such as iminodiacetic acid, nitrilotriacetic acid, ethylenediaminediacetic acid, ethylenediaminetetraacetic acid, and diethylenetriaminepentaacetic acid; soluble salts (e.g., a sodium salt, a potassium salt, and an ammonium salt) of the above organic acids; and amine compounds, such as ethylenediamine, diethylenetriamine, and triethylenetetramine.

It is preferable to use the electroless plating solution at 20°C to 98°C.

The electrolytic plating method is a method in which, for example, a current is applied to the metal constituting the metal layer (B) or the surface of the electroless plating layer (coating layer) formed by the above electroless treatment while it is in contact with an electrolytic plating solution in order to deposit the metal contained in the electrolytic plating solution, such as copper, on the conductive substance constituting the metal layer (B) or on the surface of the electroless plating layer (coating layer) formed by the above electroless treatment which is placed on the cathode and thereby form an electrolytic plating layer (metal coating layer).

Examples of the electrolytic plating solution include a plating solution containing a sulfide of a metal, such as copper, nickel, chromium, cobalt, or tin; sulfuric acid; and an aqueous medium. Specific examples thereof include a plating solution containing copper sulfate, sulfuric acid, and an aqueous medium.

It is preferable to use the electrolytic plating solution at 20°C to 98°C.

In the case where the electrolytic plating method is used, it is preferable to form a metal plating layer (C) made of copper by the electrolytic plating method in order to avoid the use of highly toxic substances and enhance workability.

Examples of the dry plating process include sputtering and vacuum vapor deposition. Sputtering is a method in which an inert gas (primarily, argon) is introduced in vacuum, negative ions are applied to the metal material forming the metal plating layer (C) in order to generate glow discharge, atoms of the inert gas are then ionized, and the gas ions are intensely impinged onto the surface of the metal material forming the metal plating layer (C) at high speeds so as to come out the atoms and molecules constituting the metal material forming the metal plating layer (C) such that they adhere onto the surface of the metal layer (B) to form a metal plating layer (C).

Examples of the metal material forming the metal plating layer (C) which is used in the sputtering method include chromium, copper, titanium, silver, platinum, gold, a nickel-chromium alloy, a stainless steel, a copper-zinc alloy, indium tin oxide (ITO), silicon dioxide, titanium dioxide, niobium oxide, and zinc oxide.

In the plating process performed by the sputtering method, for example, a magnetron sputtering apparatus may be used.

The thickness of the metal plating layer (C) is preferably 1 to 300 µm and is more preferably 1 to 50 µm. The thickness of the metal plating layer (C) can be adjusted by controlling the amount of time during which the treatment is performed in the plating process in the formation of the metal plating layer (C), the electric current density, the amount of additives used for plating, and the like.

The multilayer body according to the present invention which is produced by the above-described method may be used as a conductive pattern. In the case where the multilayer body according to the present invention is used as a conductive pattern, a conductive pattern having an intended pattern can be produced by coating or printing the fluid containing the metal powder and then performing baking such that the metal layer (B) is formed at the positions corresponding to the shape of the intended pattern that is to be formed.

The conductive pattern may be formed by, for example, a photolithography-etching method, such as a subtractive method, in which the metal layer (B) and the metal plating layer (C) are formed by pattern etching an entire-surface metal film in order to prepare a conductive pattern, or a semi-additive method; or by a method in which plating is performed on a pattern in which the metal layer (B) is to be printed.

The subtractive method is a method in which an etching resist layer having a pattern shape corresponding to the shape of the intended pattern is formed on the metal plating layer (C) constituting the multilayer body according to the present invention and the portions of the metal plating layer (C) and the metal layer (B) on which the resist is removed are dissolved and removed with a chemical solution in the subsequent developing treatment in order to form the intended pattern. The chemical solution may be a chemical solution containing copper chloride, iron chloride, or the like.

The semi-additive method is a method in which the metal layer (B) is formed on the substrate (A) directly or with the primer layer (X) interposed therebetween, the organic compounds present in the metal layer (B), such as the dispersant, are removed by the plasma discharge treatment or the like as needed, a plating resist layer having a pattern shape corresponding to the intended pattern is subsequently formed on the surface of the metal layer (B), a metal plating layer (C) is then formed by electrolytic plating or electroless plating, and the plating resist layer and the portions of the metal layer (B) which are in contact with the plating resist layer are dissolved and removed with a chemical solution or the like in order to form the intended pattern.

The method in which plating is performed on a pattern in which the metal layer (B) is to be printed is a method in which the pattern of the metal layer (B) is printed on the substrate (A) directly or with the primer layer (X) interposed therebetween by an ink jet method, a reverse printing method, or the like, the organic compounds present in the metal layer (B), such as the dispersant, are removed by the plasma discharge treatment or the like as needed, and the metal plating layer (C) is formed on the surface of the metal layer (B) by electrolytic plating or electroless plating in order to form the intended pattern.

The conductive pattern formed by the above method may be used in the production of circuit boards for electronic circuits, integrated circuit, and the like, organic solar batteries, electronic devices, organic EL devices, organic transistors, flexible printed circuit boards, wirings constituting RFIDs, and electromagnetic wave shields, because the adhesion strength between the polyphenylene sulfide constituting the substrate of the conductive pattern and the metal plating layer stacked on the substrate is excellent even while a voltage is applied to the conductive pattern in a high-temperature environment. The conductive patterns may also be used in the production of, for example, optical pickups for Blu-ray Discs, DVDs, and the like; electrical components, electric motor-related components, and battery components for hybrid vehicles and electric vehicles; and electromagnetic wave shielding materials included in various electronic devices. Furthermore, a conductive pattern that includes a film-form polyphenylene sulfide substrate may be used in the production of flexible printed circuit boards, RFID included in contactless integrated circuit cards and the like, layers constituting film capacitors, peripheral wires, and the like.

The multilayer body according to the present invention may also be used for decorative plating. The multilayer body according to the present invention may be used in the production of cellular mobile phones, personal computers, mirrors, containers, various switches, shower heads, and the like.

Furthermore, the multilayer body produced by using a molded article formed by molding the polyphenylene sulfide resin composition as a substrate (A) and stacking the metal layer (B) and the metal plating layer (C) on and above the substrate (A) in this order may be used in the production of connectors used for the connection of wires for electronic circuits, optical communication, and the like, light reflectors and the like for automobiles, and the like.

### EXAMPLES

The present invention is described in detail with reference to Examples below.

### [Production Example 1: Production of Resin Composition (1) For Primer Layer]

Into a reaction container equipped with a stirrer, a reflux cooling tube, a nitrogen introduction tube, a thermometer, a dropping funnel for addition of monomer mixtures, and a dropping funnel for addition of polymerization catalysts, 180 parts by mass of ethyl acetate was charged. While nitrogen was blown into the reaction container, the temperature was increased to 90°C. While stirring was performed, a monomer mixture including 30 parts by mass of glycidyl methacrylate, 55 parts by mass of styrene, and 15 parts by mass of methyl methacrylate and a polymerization initiator solution including 1 part by mass of azoisobutyronitrile and 20 parts by mass of ethyl acetate were added dropwise to the reaction container heated to 90°C through the different dropping funnels over 240 minutes to cause polymerization such that the temperature inside the reaction container was maintained to be 90°C ± 1°C. After the addition of the monomer mixture and the polymerization initiator solution had been completed, stirring was performed at the same temperature for 120 minutes and the temperature inside the reaction container was reduced to 30°C. Subsequently, dilution was performed with ethyl acetate. Hereby, a 2 mass% solution of an acrylic resin (1) for primer was prepared. The epoxy group equivalent was 475 g/eq.

### [Preparation Example 1: Preparation of Primer Composition (1)]

A primer composition (1) was prepared by mixing 100 parts by mass of the 2 mass% solution of the acrylic resin (1) for primer, which was prepared in Production example 1, with 1.15 parts by mass of a solution prepared by diluting pyromellitic anhydride with methyl ethyl ketone which had a solid content of 2% by mass to form a homogeneous mixture.

### [Preparation Example 2: Preparation of Primer Composition (2)]

A primer composition (2) was prepared by mixing 100 parts by mass of a solution prepared by diluting an epoxy resin ("EPICLON 1050" produced by DIC Corporation; bisphenol A-type epoxy resin, epoxy equivalent: 475 g/eq) with methyl ethyl ketone to a solid content of 2% by mass with 1.52 parts by mass of a solution prepared by diluting polyacrylic acid (produced by FUJIFILM Wako Pure Chemical Corporation, weight-average molecular weight: 5,000) with ethanol which had a solid content of 2% by mass to form a homogeneous mixture.

### [Preparation Example 3: Preparation of Primer Composition (3)]

A primer composition (3) was prepared by mixing 100 parts by mass of a solution prepared by diluting an epoxy resin ("EPICLON 830S" produced by DIC Corporation; bisphenol F-type epoxy resin, epoxy equivalent: 170 g/eq) with methyl ethyl ketone to a solid content of 2% by mass with 0.37 parts by mass of a solution prepared by diluting trimellitic anhydride with methyl ethyl ketone which had a solid content of 2% by mass to form a homogeneous mixture.

### [Preparation Example 4: Preparation of Primer Composition (4)]

A primer composition (3) was prepared by mixing 100 parts by mass of a solution prepared by diluting an epoxy resin ("EPICLON HP-4032D" produced by DIC Corporation; naphthalene-type epoxy resin, epoxy equivalent: 140 g/eq, difunctional) with methyl ethyl ketone to a solid content of 2% by mass with 4.57 parts by mass of a solution prepared by diluting trimellitic anhydride with methyl ethyl ketone which had a solid content of 2% by mass to form a homogeneous mixture.

### [Preparation Example 5: Preparation of Primer Composition (5)]

A primer composition (5) was prepared by mixing 100 parts by mass of a solution prepared by diluting an epoxy resin ("EPICLON HP-4700" produced by DIC Corporation; naphthalene-type epoxy resin, epoxy equivalent: 162 g/eq, tetrafunctional) with methyl ethyl ketone to a solid content of 2% by mass with 9.9 parts by mass of a solution prepared by diluting trimellitic anhydride with methyl ethyl ketone which had a solid content of 2% by mass to form a homogeneous mixture.

### [Preparation Example 6: Preparation of Primer Composition (6)]

A primer composition (6) was prepared by mixing 100 parts by mass of a solution prepared by diluting an epoxy resin ("EPICLON HP-4770" produced by DIC Corporation; naphthalene-type epoxy resin, epoxy equivalent: 204 g/eq, difunctional) with methyl ethyl ketone to a solid content of 2% by mass with 15.7 parts by mass of a solution prepared by diluting trimellitic anhydride with methyl ethyl ketone which had a solid content of 2% by mass to form a homogeneous mixture.

### [Preparation Example 7: Preparation of Primer Composition (7)]

A primer composition (7) was prepared by mixing 100 parts by mass of a solution prepared by diluting an epoxy resin ("EPICLON HP-7200" produced by DIC Corporation; dicyclopentadiene-phenol novolac-type epoxy resin, epoxy equivalent: 258 g/eq) with methyl ethyl ketone to a solid content of 2% by mass with 21.1 parts by mass of a solution prepared by diluting pyromellitic anhydride with methyl ethyl ketone which had a solid content of 2% by mass to form a homogeneous mixture.

### [Preparation Example 8: Preparation of Primer Composition (8)]

A primer composition (8) was prepared by mixing 100 parts by mass of a solution prepared by diluting an epoxy resin ("EPICLON HP-820" produced by DIC Corporation; alkylphenol-type epoxy resin, epoxy equivalent: 214 g/eq) with methyl ethyl ketone to a solid content of 2% by mass with 3 parts by mass of a solution prepared by diluting trimellitic anhydride with methyl ethyl ketone which had a solid content of 2% by mass to form a homogeneous mixture.

### [Preparation Example 9: Preparation of Primer Composition (9)]

A primer composition (9) was prepared by diluting an epoxy resin ("EPICLON HP-4770" produced by DIC Corporation; naphthalene-type epoxy resin, epoxy equivalent: 204 g/eq, difunctional) with methyl ethyl ketone to a solid content of 2% by mass.

### [Preparation Example 10: Preparation of Fluid (1)]

Cationic silver nanoparticles that were flaky blocks having a greenish gray metallic luster and composed of a complex of silver nanoparticles and an organic compound having a cationic group (amino group) were prepared in accordance with Example 1 described in Japanese Patent No. 4573138. The silver nanoparticle powder was dispersed in a mixed solvent including 45 parts by mass of ethylene glycol and 55 parts by mass of ion-exchange water. Hereby, a fluid
(1) that was a 5 mass% conductive ink for ink-jet printing was prepared.

### [Manufacture Example 1: Preparation of Substrate]

With 100 parts by mass of linear polyphenylene sulfide (MFR according to ASTM D1238-86: 600 g/10 min), 54.5 parts by mass of chopped glass fibers ("FT562" produced by ASAHI FIBER GLASS Co., Ltd., fibrous inorganic filler), 0.5 parts by mass of a glycidyl methacrylate-modified ethylene-methyl acrylate copolymer elastomer ("BONDFAST 7L" produced by Sumitomo Chemical Co., Ltd.), and 0.8 parts by mass of a montanic acid complex ester wax ("Licolub WE40" produced by Clariant Japan K.K.) were mixed to form a homogeneous mixture. The mixture was melt-kneaded at 290°C to 330°C with a twin-screw extruder having a diameter of 35 mm to prepare a polyphenylene sulfide resin composition. The polyphenylene sulfide resin composition was molded with an injection molding machine. Hereby, a substrate having a size of 50 mm × 105 mm × 2 mm was prepared.

### [Example 1]

The primer composition (1) prepared in Preparation example 1 was coated onto the surface of the substrate prepared in Manufacture example 1 with a spin coater such that the resulting coating layer had a thickness of 0.1 µm after dried. The coating layer was then dried at 120°C for 5 minutes with a hot-air dryer to form a primer layer on the substrate.

The fluid (1) prepared in Preparation example 10 was coated onto the entire surface of the primer layer with an ink-jet printer ("Ink-jet test machine EB100" produced by Konica Minolta, Inc., evaluation printer head: KM512L, ejection rate: 42 pL). Subsequently, baking was performed at 200°C for 30 minutes. Hereby, a silver layer (thickness: about 0.1 µm) corresponding to the metal layer (B) was formed.

Then, while the surface of the silver layer was placed on the cathode and phosphorus-containing copper was placed on the anode, electroplating was performed with an electroplating solution containing copper sulfate at an electric current density of 2.5 A/dm² for 40 minutes to form a copper plating layer having a thickness of 15 µm on the surface of the silver layer. The electroplating solution used contained 70 g/liter of copper sulfate, 200 g/liter of sulfuric acid, 50 mg/liter of chlorine ion, and 5 g/liter of TOP LUCINA SF (brightening agent produced by Okuno Chemical Industries Co., Ltd.).

A multilayer body (1) including the substrate (A), the primer layer (X), the metal layer (B), and the metal plating layer (C) stacked on top of one another in this order was prepared by the above-described method.

### [Examples 2 to 9]

Multilayer bodies (2) to (9) each including the substrate (A), the primer layer (X), the metal layer (B), and the metal plating layer (C) stacked on top of one another in this order were prepared by the same method as in Example 1, except that the primer compositions (2) to (9) prepared in Preparation examples 2 to 9 were used, respectively, instead of the primer composition (1) used in Example 1.

### [Comparative Example 1]

A multilayer body (R1) including the substrate (A), the metal layer (B), and the metal plating layer (C) stacked on top of one another in this order was prepared by the same method as in Example 1, except that the silver layer was formed directly on the substrate without forming the primer layer.

The peel strength of each of the multilayer bodies (1) to (9) and (R1) was measured and evaluated as described below before and after the multilayer body was heated.

### <Measurement of Peel Strength Before Heating>

The peel strength of each of the multilayer bodies prepared above was measured with "AUTOGRAPH AGS-X 500N" produced by Shimadzu Corporation. The width of the lead used in the measurement was 5 mm. The peel angle was 90°. The peel strength is likely to increase with an increase in the thickness of the metal plating layer; in the present invention, the peel strength measured when the thickness of the metal plating layer was 15 µm was used as a reference in the measurement.

### <Measurement of Peel Strength After Heating>

Each of the multilayer bodies was heated by being placed in a dryer set at 150°C for 168 hours. After the multilayer body had been heated, peel strength was measured by the same method as described above.

### <Heat Resistance Evaluation>

The retention rate at which peel strength was retained during heating was calculated using the peel strengths measured before and after heating. Heat resistance was evaluated in accordance with the following standards.
A: The retention rate was 80% or more.
B: The retention rate was 70% or more and less than 80%.
C: The retention rate was 50% or more and less than 70%.
D: The retention rate was less than 50%.

Table 1 describes the results of measurement of the peel strengths of each of the multilayer bodies prepared in Examples 1 to 9 and Comparative example 1 before and after heating and the results of evaluation of heat resistance.

**[Table 1]**

| | | | Example 1 | Example 2 | Example 3 | Example 4 | Example 5 | Example 6 | Example 7 | Example 8 | Example 9 | Comparative example 1 |
|---|---|---|---|---|---|---|---|---|---|---|---|---|
| Multilayer body | | | (1) | (2) | (3) | (4) | (5) | (6) | (7) | (8) | (9) | (R1) |
| Primer composition | | | (1) | (2) | (3) | (4) | (5) | (6) | (7) | (8) | (9) | - |
| Acrylic resin for primer | | | (1) | - | - | - | - | - | - | - | - | - |
| Epoxy resin for primer | | | - | EPICLO N 1050 | EPICLON 830S | EPICLON HP-4032D | EPICLON HP-4700 | EPICLON HP-4770 | EPICLON HP-7200 | EPICLON HP-820 | EPICLON HP-4770 | - |
| Carboxylic acid | | | Pyromellitic anhydride | Polyacry lic acid | Trimellitic anhydride | Trimellitic anhydride | Trimellitic anhydride | Trimellitic anhydride | Pyromellitic anhydride | Trimellitic anhydride | - | - |
| Molar ratio of carboxyl group/epoxy group (xA/xE) | | | 0.1 | 0.1 | 0.01 | 0.1 | 0.25 | 0.5 | 1 | 0.1 | - | - |
| Evaluatio n results | Peel strength of multilayer body (N/m) | Before heating | 350 | 420 | 400 | 450 | 800 | 790 | 400 | 300 | 620 | 200 |
| | | After heating | 270 | 390 | 380 | 380 | 700 | 680 | 390 | 300 | 490 | 10 |
| | Peel strength retention rate (%) | | 77 | 93 | 95 | 84 | 88 | 86 | 98 | 100 | 79 | 5 |
| | Heat resistance | | B | A | A | A | A | A | A | A | B | D |

The results described in Table 1 confirm that each of the multilayer bodies (1) to (9) prepared in Examples 1 to 9, which is the multilayer body according to the present invention, had a high peel strength, the reduction in the peel strength of the multilayer body after heating was small, and the retention rate at which peel strength was retained after heating was high, that is, the multilayer body had excellent heat resistance.

In contrast, the peel strength of the multilayer body (R1) prepared in Comparative example 1 which was measured before heating was lower than that of the multilayer body according to the present invention, and the peel strength of the multilayer body (R1) was significantly reduced after heating. This confirms that the multilayer body (R1) had poor heat resistance.

## Claims

1. A multilayer body comprising a substrate (A) including a polyphenylene sulfide resin composition and a primer layer (X), a metal layer (B), and a metal plating layer (C) that are stacked on and above the substrate (A), the primer layer (X) including an aromatic resin (x1) having an epoxy group.

2. The multilayer body according to Claim 1, wherein the primer layer (X) further includes a carboxylic acid (x2).

3. The multilayer body according to Claim 2, wherein a molar ratio [(xA)/(xE)] of a carboxyl group (xA) included in the carboxylic acid (x2) included in the primer layer (X) to an epoxy group (xE) included in the aromatic resin (x1) is 0.01 to 1.

4. The multilayer body according to any one of Claims 1 to 3, wherein the substrate (A) further includes an elastomer.

5. The multilayer body according to any one of Claims 1 to 4, wherein a metal constituting the metal layer (B) is at least one selected from the group consisting of copper, silver, gold, nickel, palladium, platinum, cobalt, and chromium.

6. The multilayer body according to any one of Claims 1 to 5, wherein the metal plating layer (C) is formed by electrolytic plating, electroless plating, or a combination of electrolytic plating and electroless plating.

7. A molded article comprising the multilayer body according to any one of Claims 1 to 6.

8. A conductive pattern comprising the multilayer body according to any one of Claims 1 to 6.

9. An electronic circuit comprising the conductive pattern according to Claim 8.
